# EUROPEAN PATENT APPLICATION

(11) **EP 4 299 789 A1**
(43) Date of publication of application: **03.01.2024**
(21) Application number: 22759380.3
(22) Date of filing: 09.02.2022
(51) Int. Cl.: C23C 16/513, H01L 21/3065, H05H 1/26

(54) **FILM-FORMING METHOD AND ATMOSPHERIC PRESSURE PLASMA FILM-FORMING DEVICE**

(30) Priority: 26.02.2021 JP 2021030695
(71) Applicant: FUJIFILM Corporation, Tokyo 106-8620 (JP)
(72) Inventor: YOSHIDA, Akihisa, Minamiashigara-shi, Kanagawa 250-0193 (JP); MOCHIZUKI, Yoshihiko, Minamiashigara-shi, Kanagawa 250-0193 (JP)
(74) Representative: Klunker IP Patentanwälte PartG mbB
(86) International application number: PCT/JP2022/005145
(87) International publication number: WO 2022/181341

(57) **Abstract**

An object of the present invention is to provide a film forming method and an atmospheric plasma film forming apparatus capable of forming a film having high flatness at a high film forming speed by using atmospheric plasma film formation. The object is achieved by introducing plasma generation gas from an inner side flow passage that passes between a pair of electrodes, by introducing raw material gas from at least one of a first outer side flow passage or a second outer side flow passage that pass through an outer side of the pair of electrodes, and by making a gas flow rate between an outlet port of the first outer side flow passage and a substrate and a gas flow rate between an outlet port of the second outer side flow passage and the substrate unequal.

## Description

### BACKGROUND OF THE INVENTION

### 1. Field of the Invention

The present invention relates to a film forming method using atmospheric plasma and an atmospheric plasma film forming apparatus that performs the film forming method.

### 2. Description of the Related Art

Atmospheric plasma film formation is known in which a film formation is performed on a substrate with active species of raw material gas by generating plasma under atmospheric pressure (near atmospheric pressure) and activating raw material gas.

Since the atmospheric plasma film formation is performed under atmospheric pressure, it does not require an expensive vacuum container such as a vacuum chamber, thereby there is an advantage that the apparatus cost can be reduced. Further, there is an advantage that processing is possible even for a substrate that is difficult to perform processing under vacuum.

In an atmospheric plasma film formation, plasma is generated by introducing plasma generation gas such as inert gas between electrodes, and raw material gas, which contains a film forming material, is activated using the plasma. In the atmospheric plasma, the film formation is performed by adhering active species of the film forming material, which is obtained according to the above description, to the substrate.

Here, in the atmospheric plasma film formation, in order to suppress adhesion of the film forming material on the electrode, a type of separately introducing the raw material gas and the plasma generation gas and forming a film by contacting and mixing the plasma, which is generated between a pair of electrodes, with the raw material gas outside the pair of electrodes, is generally used. Hereinafter, this atmospheric plasma type is also referred to as a "remote diffusion mixing type".

In the remote diffusion mixing type atmospheric plasma film formation, normally, the plasma and the raw material gas are mixed in a mixing portion between the pair of electrodes and the substrate by introducing the plasma generation gas with a space between the pair of electrodes as an inner side flow passage and by introducing the raw material gas from an outer side flow passage provided to interpose the inner side flow passages on an outer side between the pair of electrodes.

For example, in JP2009-506496A, an atmospheric plasma film forming apparatus and a method are described, which include a pair of electrodes, a voltage application unit that applies a voltage between the electrodes, an inert gas supply unit that supplies inert gas between the electrodes, and a raw material gas supply unit, in which a substrate (a film formation body target) is disposed downstream of the pair of electrodes in a flow direction of the inert gas, the substrate is disposed on a conductor, the raw material gas is supplied to the outside of the pair of electrodes between the pair of electrodes and the substrate, and furthermore, the pair of electrodes is disposed perpendicular to a planar direction of the substrate, and the inert gas is supplied between the pair of electrodes parallel to the pair of electrodes.

In such a remote diffusion mixing type atmospheric plasma film formation, in order to improve the decomposability of the raw material gas and improve a film forming speed, in the mixing portion between the pair of electrodes and the substrate, it is preferable to bring the plasma and the raw material gas into contact for a long enough time for the activation reaction of the raw material gas.

That is, in the remote diffusion mixing type atmospheric plasma film formation, in order to improve the film forming speed, it is preferable to lengthen the residence time of the raw material gas in the mixing portion to lengthen the mixing reaction time of the plasma and the raw material gas.

On the other hand, as described in Behavior of fine particles in plasma CVD process and fine particle contamination control method Yutaka Hayashi, Manabu Shimada, J. Aerosol Res., 21, 3, p.209 (2006), in the atmospheric plasma film formation, in the mixing portion which is a gas phase, in a case where the decomposed raw material gas (active species) stays for a long time, the active species of the raw material gas aggregate to form fine particles.

In a case where such fine particles adhere to the substrate, the flatness of the film, in which the film formation is performed, is impaired, and the quality of the product deteriorates. Depending on the product to be manufactured, it is necessary to maintain the flatness of the film on the order of several nm with, for example, an arithmetic average roughness Ra. Therefore, in this application, it is difficult to improve the film forming speed while maintaining the flatness.

### SUMMARY OF THE INVENTION

As described above, in the remote diffusion mixing type atmospheric plasma film formation in the related art, it has been difficult to improve the film forming speed while ensuring the flatness of the film, which is used for the film formation.

Therefore, the advent of a method of realizing the remote diffusion mixing type atmospheric plasma film formation capable of forming a high-quality film having high flatness with high productivity is desired.

An object of the present embodiment of the present invention is to solve such a problem in the related art and is to provide a film forming method and an atmospheric plasma film forming apparatus capable of performing a film formation on a high-quality film having high flatness at a high film forming speed by using the remote diffusion mixing type atmospheric plasma.

In order to achieve the above-described object, an aspect of the present embodiment of the present invention has the following configurations.
[1] A film forming method comprises: in a case where, between a pair of electrodes and a substrate, plasma generation gas is introduced from an inner side flow passage that passes between the pair of electrodes and raw material gas is also introduced from at least one of a first outer side flow passage or a second outer side flow passage that are positioned on an outer side between the pair of electrodes, and then a film formation is performed on the substrate by using atmospheric plasma, and in a case where a gas flow rate between an outlet port of the first outer side flow passage and the substrate is defined as a first gas flow rate, and a gas flow rate between an outlet port of the second outer side flow passage and the substrate is defined as a second gas flow rate, performing the film formation on the substrate by making the first gas flow rate and the second gas flow rate unequal.
[2] In the film forming method according to [1], the raw material gas is introduced from at least an outer side flow passage corresponding to a higher flow rate side of the first gas flow rate and the second gas flow rate.
[3] In the film forming method according to [1] or [2], the raw material gas is introduced from both sides of the first outer side flow passage and the second outer side flow passage.
[4] In the film forming method according to any one of [1] to [3], the first gas flow rate and the second gas flow rate are made unequal by setting an introduction amount of gas from the first outer side flow passage and an introduction amount of gas from the second outer side flow passage different from each other.
[5] In the film forming method according to any one of [1] to [4], the first gas flow rate and the second gas flow rate are made unequal by setting the outlet port of the first outer side flow passage and the outlet port of the second outer side flow passage different in area.
[6] In the film forming method according to any one of [1] to [5], the first gas flow rate and the second gas flow rate are made unequal by providing an air supply unit on one of the first outer side flow passage or the second outer side flow passage on a side opposite to the inner side flow passage and by supplying air from the air supply unit.
[7] In the film forming method according to any one of [1] to [6], the first gas flow rate and the second gas flow rate are made unequal by providing an exhaust unit on one of the first outer side flow passage or the second outer side flow passage on a side opposite to the inner side flow passage and by discharging gas from the exhaust unit.
[8] In the film forming method according to any one of [1] to [7], the first gas flow rate and the second gas flow rate are made unequal by setting a shape of a surface, which faces the substrate, of an electrode forming the pair of electrodes different between the first outer side flow passage side and the second outer side flow passage side.
[9] An atmospheric plasma film forming apparatus comprises: a pair of electrodes; a substrate holding unit that holds a substrate; an inner side flow passage that passes between the pair of electrodes and that allows gas to be introduced between the pair of electrodes and the substrate holding unit; a first outer side flow passage and a second outer side flow passage that pass through an outer side between the pair of electrodes and that allow gas to be introduced between the pair of electrodes and the substrate holding unit; and a flow rate control unit that makes, in a case where a gas flow rate between an outlet port of the first outer side flow passage and the substrate holding unit is defined as a first gas flow rate, and a gas flow rate between an outlet port of the second outer side flow passage and the substrate holding unit is defined as a second gas flow rate, the first gas flow rate and the second gas flow rate unequal.

According to the present embodiment of the present invention, a film formation can be performed on a high-quality film having high flatness at a high film forming speed by using the remote diffusion mixing type atmospheric plasma.

### BRIEF DESCRIPTION OF THE DRAWINGS

Fig. 1 is a diagram conceptually showing an example of an atmospheric plasma film forming apparatus according to an embodiment of the present invention, which performs an example of a film forming method of the embodiment of the present invention.
Fig. 2 is a conceptual diagram for describing the present embodiment of the present invention.
Fig. 3 is a conceptual diagram for describing an atmospheric plasma film formation according to the present embodiment of the present invention in the related art.
Fig. 4 is a graph describing the present embodiment of the present invention.
Fig. 5 is a graph showing a measurement result of a gas flow velocity in Example of the present embodiment of the present invention.
Fig. 6 is a graph showing a result of the Example of the present embodiment of the present invention.
Fig. 7 is an enlarged view of a part of Fig. 6.
Fig. 8 is a conceptual diagram for describing the remote diffusion mixing type atmospheric plasma film formation.

### DESCRIPTION OF THE PREFERRED EMBODIMENTS

Hereinafter, a film forming method and an atmospheric plasma film forming apparatus according to the embodiment of the present invention will be described in detail with reference to suitable Examples shown in the accompanying drawings.

The description of the configuration requirements described below is based on a representative embodiment of the present invention, but the embodiment of the present invention is not limited to such an embodiment.

In the present specification, a numerical range represented by using "to" means a range including numerical values before and after "to" as the lower limit value and the upper limit value.

Further, the drawings shown below are conceptual diagrams for describing the embodiment of the present invention. Therefore, the sizes, lengths, positional relationships, and the like of the configuration members do not always match those of actual objects.

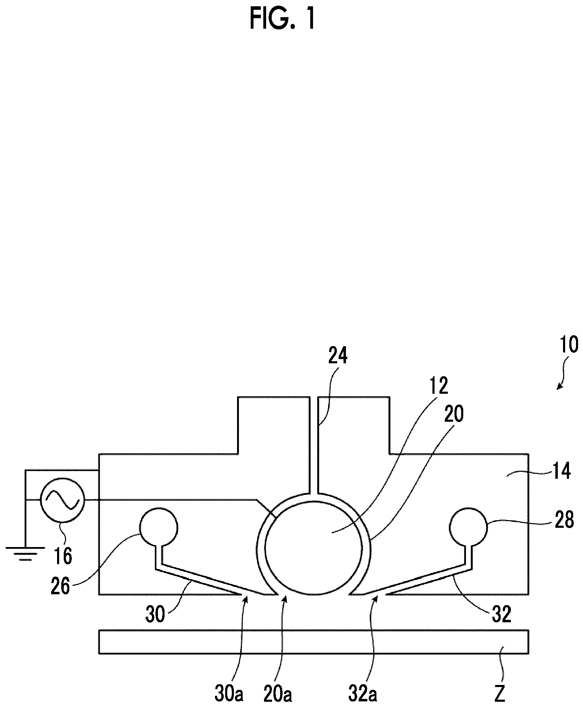

Fig. 1 is a diagram conceptually showing an example of an atmospheric plasma film forming apparatus according to an embodiment of the present invention, which performs an example of a film forming method of the embodiment of the present invention.

The atmospheric plasma film forming apparatus 10 shown in Fig. 1 is an apparatus that performs a film formation on a substrate Z by using the remote diffusion mixing type atmospheric plasma (the atmospheric plasma chemical vapor deposition (CVD)) described above. Therefore, the atmospheric plasma film forming apparatus 10 performs the film formation on the substrate Z by separately introducing the raw material gas and the plasma generation gas under the atmospheric pressure (near the atmospheric pressure) and by contacting and mixing the plasma, which is generated between the pair of electrodes, with the raw material gas between the pair of electrodes and the substrate Z.

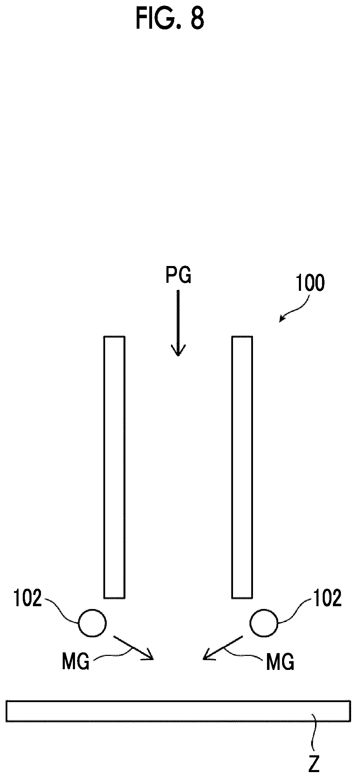

Specifically, as shown conceptually in Fig. 8 as an example of a general configuration, in the remote diffusion mixing type atmospheric plasma film forming apparatus, plasma is generated by introducing plasma generation gas PG between the pair of electrodes 100 and the plasma is introduced between the pair of electrodes 100 and the substrate Z. Further, the raw material gas MG is introduced between the pair of electrodes and the substrate Z from the outer side flow passage 102 provided on the outer side between the pair of electrodes 100. As a result, the plasma that is generated between the pair of electrodes is made in contact with and mixed with the raw material gas between the pair of electrodes and the substrate Z, and the film formation is performed on the substrate Z.

In the following description, the atmospheric plasma film forming apparatus is also simply referred to as a film forming apparatus.

In the embodiment of the present invention, the substrate Z (a film formation substrate target), which is used for the film formation, is not limited, and various known substrates that can be used for the film formation by using the remote diffusion mixing type atmospheric plasma can be used.

An example includes a resin film (a polymer film, a plastic film) made of a polymer material such as polyethylene terephthalate (PET), polyethylene polyvinyl chloride, polyethylene, polypropylene, polystyrene, polyamide, polyvinyl chloride, polycarbonate, polyacrylonitrile, polyimide, polyacrylate, and polymethacrylate, as well as a silicon substrate.

Further, the film that is used for the film formation on the substrate Z is not limited, and various known materials that can be used for the film formation by using the remote diffusion mixing type atmospheric plasma film formation, can be used.

Examples include a gas barrier film such as silicon oxide, silicon oxynitride, silicon nitride, and aluminum oxide, a light reflection film or an antireflection film such as silicon oxide, titanium oxide, zinc oxide, tin oxide, and fluorine compounds, and a transparent conductive film such as indium tin oxide, tin oxide, indium oxide, zinc oxide, indium-cadmium oxide, cadmium-tin oxide, cadmium oxide, and gallium oxide, as well as a diamond like carbon (DLC) film.

Further, various known raw material gas and plasma generation gas in accordance with the film, which is used for the film formation, can be used. The raw material gas is gas containing a component that becomes a film, which is used for the film formation, and the plasma generation gas is gas for generating plasma.

As an example, in a case where a DLC film is used for the film formation, hydrocarbon gas such as methane gas and acetylene gas is exemplified as the raw material gas, and argon gas is exemplified as the plasma generation gas, respectively. In a case where a silicon oxide film is used for the film formation, tetraethoxysilane (TEOS) gas is exemplified as the raw material gas, and nitrogen gas is exemplified as the plasma generation gas.

The film forming apparatus 10 shown in Fig. 1 includes a cylindrical electrode 12, a film forming unit 14, and an AC power source 16.

In Fig. 1, the cylindrical electrode 12 and the film forming unit 14 are cross-sectional views, and in order to simplify the drawing and clearly show the configuration of the film forming apparatus 10, hatching is omitted.

Further, in the following description, for convenience, positions of each of the members are represented as top and bottom and horizontal (right and left) according to Fig. 1. However, the vertical direction (top-bottom direction) and the lateral direction (horizontal direction) do not necessarily match the actual usage state of the film forming apparatus 10.

The cylindrical electrode 12 is a cylindrical-shaped electrode in which a direction orthogonal to a paper surface in Fig. 1 is a height direction (axis direction). The cylindrical electrode 12 is not limited, and various known cylindrical electrodes used for the atmospheric plasma film formation by so-called dielectric barrier discharge, can be used.

Examples of the cylindrical electrode 12 include an electrode in which the surface of a cylinder made of a conductive material such as metal is covered with a dielectric such as quartz glass.

The film forming unit 14 is a block-shaped member made of metal.

The film forming unit 14 is provided with a flow passage formation portion 20 at a lower center portion in the lateral direction. The flow passage formation portion 20 is a cylindrical-shaped space having an inner diameter larger than an outer diameter of the cylindrical electrode 12 in which the direction orthogonal to the paper surface is the height direction. The lower end of the flow passage formation portion 20 is open from the lower end of the film forming unit 14. That is, the film forming unit 14 includes a slit shaped discharge port 20a, which has a longitudinal direction in a direction orthogonal to a paper surface, at a lower center end in a lateral direction.

Further, a plasma generation gas supply passage 24 is provided to penetrate from the upper end of the flow passage formation portion 20 to the upper surface of the film forming unit 14. A supply source of plasma generation gas (not shown) is connected to the plasma generation gas supply passage 24.

In the film forming apparatus 10, a space between the cylindrical electrode 12 and the film forming unit 14 serves as the inner flow passage for introducing the plasma generation gas. In other words, the space between the cylindrical electrode 12 and an inner wall surface of the flow passage formation portion 20 is the inner flow passage.

Therefore, the plasma generation gas is made into plasma by the dielectric barrier discharge and is introduced between the pair of electrodes and the substrate from the discharge port 20a on the lower surface of the film forming unit 14 while passing through the inner side flow passage between the cylindrical electrode 12 and the film forming unit 14 from the plasma generation gas supply passage 24. That is, the discharge port 20a is a discharge port for gas from the inner flow passage.

The film forming unit 14 is provided with a first raw material gas supply passage 26 and a second raw material gas supply passage 28 to interpose the flow passage formation portion 20 in the lateral direction. Both the first raw material gas supply passage 26 and the second raw material gas supply passage 28 are cylindrical-shaped spaces having the height direction in a direction orthogonal to the paper surface.

The supply source of the raw material gas (not shown) is connected to both the first raw material gas supply passage 26 and the second raw material gas supply passage 28.

The film forming unit 14 is further provided with a first outer side flow passage 30 and a second outer side flow passage 32.

The first outer side flow passage 30 communicates from the first raw material gas supply passage 26 to the discharge port 30a on the lower surface of the film forming unit 14. The discharge port 30a is positioned on the left side of the discharge port 20a of the inner side flow passage. The discharge port 30a is a slit shaped opening having a longitudinal direction in a direction orthogonal to the paper surface.

The second outer side flow passage 32 communicates from the second raw material gas supply passage 28 to the discharge port 32a on the lower surface of the film forming unit 14. The discharge port 32a is positioned on the right side of the discharge port 20a of the inner side flow passage. The discharge port 32a is a slit shaped opening having a longitudinal direction in a direction orthogonal to the paper surface.

The lengths of slits of the discharge port 20a of the inner side flow passage, the discharge port 30a of the first outer side flow passage 30, and the discharge port 32a of the second outer side flow passage 32 may be appropriately set according to the length of the substrate Z, on which the film formation is assumed, in a direction orthogonal to the paper surface.

Note that, in the present embodiment of the present invention, the terms "first" and "second" attached to each member, and the terms "first" and "second" in the first gas flow rate and the second gas flow rate described later are used for convenience in order to distinguish each other, and have no technical meaning.

Therefore, the terms "first" and "second" are irrelevant to their respective positional relationships, actions, gas flow rates, upstream and downstream of gas flows, and the like.

In the atmospheric plasma film formation, normally, the film formation is performed on the substrate Z while relatively moving the pair of electrodes and the substrate. In the atmospheric plasma film formation, in many cases, the pair of electrodes and the substrate are relatively moved by transporting the substrate Z.

Here, in the remote diffusion mixing type atmospheric plasma film formation, normally, outer side flow passages (discharge ports) for introducing the raw material gas are provided to interpose the inner side flow passage (discharge port) in the transport direction of the substrate.

Therefore, in the film forming apparatus 10, in a preferred aspect, the discharge port 30a of the first outer side flow passage 30 and the discharge port 32a of the second outer side flow passage 32 are provided to interpose the discharge port 20a of the inner side flow passage in the transport direction of the substrate Z. Further, in a preferred aspect, the discharge port 20a of the inner side flow passage, the discharge port 30a of the first outer side flow passage 30, and the discharge port 32a of the second outer side flow passage 32 have a slit shape having the longitudinal direction in a direction orthogonal to the transport direction of the substrate Z.

In the present embodiment of the present invention, the relative movement between the pair of electrodes and the substrate Z may be performed by fixing the pair of electrodes and transporting the substrate Z as described above, may be performed by fixing the substrate Z and transporting the pair of electrodes, or may be performed by moving both the pair of electrodes and the substrate Z.

Although not shown, the film forming apparatus 10 in the illustrated example includes a transporting unit for the substrate Z. The transporting unit for the substrate Z is a substrate holding unit in the film forming apparatus of the present embodiment of the present invention. The transporting unit for the substrate Z is a known substrate transporting unit used in the remote diffusion mixing type atmospheric plasma film formation.

Note that, in the present embodiment of the present invention, the film formation may be performed on the substrate Z in a state where both the pair of electrodes and the substrate Z are stopped without relatively moving the pair of electrodes and the substrate Z.

The film forming method and the film forming apparatus according to the present embodiment of the present invention are not limited to the configuration in which the cylindrical electrode is used as in the film forming apparatus 10 shown in Fig. 1.

That is, in the present embodiment of the present invention, as described later, in a case where the first gas flow rate and the second gas flow rate are made unequal, various types of known remote diffusion mixing type atmospheric plasma film formation can be used. As an example, the atmospheric plasma film formation, which uses a configuration in which a space between two flat plate electrodes disposed in parallel is defined as an inner side flow passage and a first and second outer side flow passages that are positioned below the flat plate electrode are included, as shown in the above-mentioned JP2009-506496A, and the atmospheric plasma film formation, which uses a configuration as shown in Fig. 8, are exemplified.

Here, the flat plate electrode has corner portions. Therefore, in a case where the electrode and the substrate are brought close to each other, an abnormal discharge may occur. In contrast, since the cylindrical electrode does not have a corner portion, it is extremely unlikely that an abnormal discharge occurs even in a case where the electrode and the substrate are brought close to each other. In consideration of this point, in the embodiment of the present invention, it is preferable to use the cylindrical electrode 12 such as the film forming apparatus 10 in the illustrated example, rather than the flat plate electrode.

In the film forming apparatus 10, the AC power source 16 is connected to the cylindrical electrode 12. Further, the cylindrical electrode 12 and the film forming unit 14 configuring the pair of electrodes are grounded.

Therefore, by applying an AC voltage to the cylindrical electrode 12, a dielectric barrier discharge is generated between the cylindrical electrode 12 and the film forming unit 14 (the inner wall surface of the flow passage formation portion 20). As a result, the plasma generation gas, which flows between the cylindrical electrode 12 that is the inner flow passage and the film forming unit 14, is excited, and plasma is generated.

The AC power source 16 is a known high-frequency AC power source used for the remote diffusion mixing type atmospheric plasma film formation.

In the embodiment of the present invention, a frequency (frequency of the plasma excitation voltage) and an output (plasma excitation power) of the AC power source 16 are not limited, and the frequency and the output may be appropriately set according to the film that is used for the film formation, the raw material gas, the plasma generation gas, the desired film forming speed, or the like.

In the embodiment of the present invention, a pulse power source may be used instead of the AC power source.

In the film forming apparatus 10 shown in Fig. 1, at the time of the film formation on the substrate Z, similar to the known remote diffusion mixing type atmospheric plasma film formation, the plasma generation gas is supplied between the cylindrical electrode 12 that is the inner flow passage and the film forming unit 14 (the inner wall surface of the flow passage formation portion 20) while applying the AC voltage to the cylindrical electrode 12. As a result, the plasma is generated by exciting the plasma generation gas, which passes through the inner flow passage, and the plasma generation gas, which includes the plasma, is introduced between the pair of electrodes and the substrate Z from the discharge port 20a. In the film forming apparatus 10, the cylindrical electrode 12 and the film forming unit 14 configure the pair of electrodes as described above.

In parallel, the raw material gas is supplied to the first outer side flow passage 30 and the second outer side flow passage 32, and the raw material gas is introduced from the discharge port 30a and the discharge port 32a between the electrode and the substrate Z.

As a result, the plasma and the raw material gas are diffused and mixed between the pair of electrodes and the substrate Z, the raw material gas is activated, and the film formation is performed on the substrate Z by the active species of the generated raw material gas. In the following description, a region between the pair of electrodes and the substrate Z where the plasma and the raw material gas are diffused and mixed is also simply referred to as a "mixing portion".

Here, in the film forming apparatus 10 (the film forming method) of the present embodiment of the present invention, in a case where a gas flow rate between the discharge port 30a of the first outer side flow passage 30 and the substrate Z is defined as the first gas flow rate, and a gas flow rate between the discharge port 32a of the second outer side flow passage 32 and the substrate Z is defined as the second gas flow rate, the film formation is performed on the substrate Z by making the first gas flow rate and the second gas flow rate unequal.

The gas flow rate referred to here is a gas flow rate that flows in a plane direction of the substrate Z from the first outer side flow passage 30 toward the second outer side flow passage 32 or from the second outer side flow passage 32 toward the first outer side flow passage 30, through any cross section between the pair of electrodes and the substrate Z. As an example of any cross section, a cross section of a flow passage below the discharge port 32a, which is perpendicular to the substrate Z and the paper surface, is exemplified.

In the illustrated example, as an example, by setting an introduction amount of gas (a flow rate) from the first outer side flow passage 30 to the mixing portion and an introduction amount of gas from the second outer side flow passage 32 to the mixing portion to be different amounts, the film formation is performed on the substrate Z by making the first gas flow rate and the second gas flow rate unequal.

In the present embodiment of the present invention, by having such a configuration, it is possible to suppress the aggregation of active species of the raw material gas to generate fine particles, and to perform the film formation on a film with high flatness at a high film forming speed.

As described above, in the remote diffusion mixing type atmospheric plasma film formation, in order to improve the decomposability of the raw material gas and improve a film forming speed, in the mixing portion between the pair of electrodes and the substrate, it is preferable to lengthen the residence time of the raw material gas to lengthen the mixing reaction time of the plasma and the raw material gas.

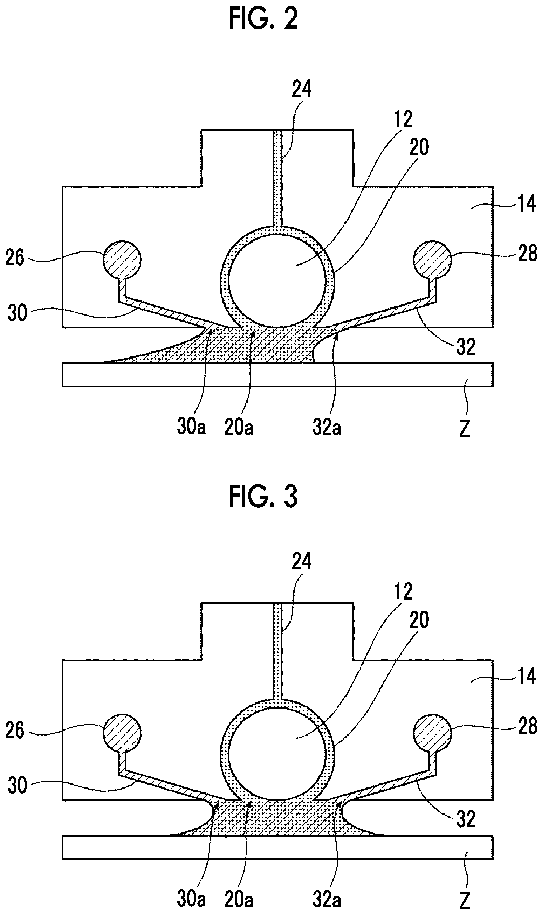

For example, the introduction amount of gas to the first outer side flow passage 30 and the introduction amount of gas to the second outer side flow passage 32 are made equal. Thereby, as conceptually shown in Fig. 3, the flow of gas in the mixing portion between the pair of electrodes and the substrate Z can be suppressed. As a result, the mixing reaction time of the plasma and the raw material gas can be lengthened by increasing the residence time of the raw material gas in the mixing portion.

On the other hand, in the film formation by using the atmospheric plasma, in the mixing portion which is a gas phase, in a case where the decomposed raw material gas (active species) stays for a long time, the active species of the raw material gas aggregate to form fine particles. In a case where such fine particles adhere to the substrate, the flatness of the film, in which the film formation is performed, is impaired, and the quality deteriorates.

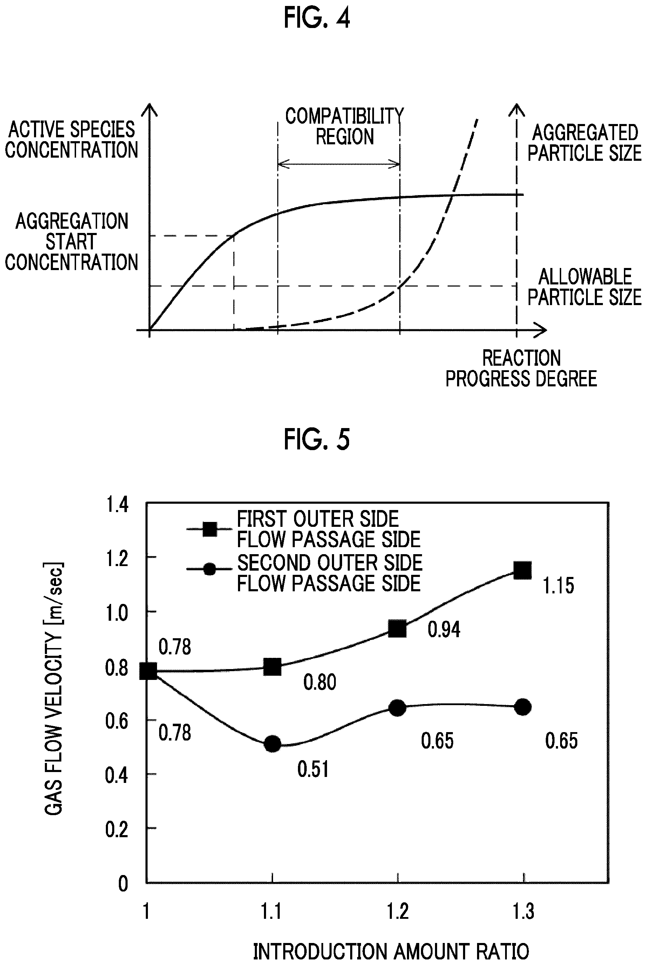

Fig. 4 conceptually shows, in the mixing portion of the remote diffusion mixing type atmospheric plasma film formation, a relationship between a reaction progress degree and concentration (solid line) of the decomposed raw material gas, that is, active species, and a relationship between the reaction progress degree and the aggregated particle size (broken line) of particles in which active species are aggregated.

According to the studies by the present inventors, as shown in Fig. 4, as the reaction in the mixing portion proceeds, the concentration of the decomposed raw material gas, that is, the active species increases. Further, as shown in Fig. 4, in a case where the concentration of the active species reaches a certain level, aggregation of the active species is started, and the aggregated particle size increases with the progress of the reaction. As a result, when the reaction progress degree exceeds a certain point, the aggregated particle size due to the aggregation of the active species exceeds an allowable particle size.

Note that, the reaction progress degree is a variable that conceptually represents a progress degree of the reaction that occurs between the raw material gas and the plasma, which is influenced by the residence time, temperature, activation energy, diffusion coefficient, or the like of the raw material gas in the mixing portion.

The film forming speed is affected by the concentration of the active species. Therefore, by increasing the reaction progress degree to some extent, the concentration of the active species can be ensured and the film forming speed can be increased.

On the other hand, as shown in Fig. 4, by suppressing the reaction progress degree to a certain extent or less, the aggregated particle size can be suppressed to be equal to or less than the allowable particle size.

Here, the reaction progress degree is influenced by the residence time, temperature, activation energy, diffusion coefficient, or the like of the raw material gas in the mixing portion.

Therefore, the reaction progress degree can be controlled by controlling the residence time of the raw material gas in the mixing portion. Further, by controlling the reaction progress degree, it is possible to maintain the concentration of the active species in the mixing portion near the maximum value, ensure a sufficient film forming speed, and suppress the aggregated particle size to be equal to or less than the allowable particle size.

The present embodiment of the present invention has been achieved by obtaining such findings and makes the first gas flow rate, which is a gas flow rate between the discharge port 30a of the first outer side flow passage 30 and the substrate Z, and the second gas flow rate, which is a gas flow rate between the discharge port 32a of the second outer side flow passage 32 and the substrate Z, unequal. Accordingly, the present embodiment of the present invention controls the residence time, that is, the reaction progress degree of the raw material gas in the mixing portion and makes it possible to perform the film formation on a high-quality film with high flatness at a high film forming speed while ensuring the reaction rate and suppressing the aggregation of active species as in the compatibility region shown in Fig. 4.

In other words, in the present embodiment of the present invention, the flow of raw material gas in the mixing portion is controlled in a low-speed range by making the first gas flow rate and the second gas flow rate unequal. That is, in the present embodiment of the present invention, the flow velocity of the raw material gas in the mixing portion is set to a state close to zero, and then the raw material gas is allowed to flow slightly by making the first gas flow rate and the second gas flow rate unequal.

Accordingly, the present embodiment of the present invention makes it possible to suppress the aggregation of the active species and perform the film formation on a flat film by preventing the residence time of the raw material gas in the mixing portion from being longer than necessary, in addition to improving the film forming speed by sufficiently ensuring the residence time of the raw material gas, that is, the mixing time of the raw material gas and the plasma, in the mixing portion.

In the illustrated example, as an example, the introduction amount of gas from the second outer side flow passage 32 to the mixing portion is set to be larger than the introduction amount of gas from the first outer side flow passage 30 to the mixing portion. Accordingly, as conceptually shown in Fig. 2, a low-speed gas flow is formed in the surface direction of the substrate Z from the discharge port 32a of the second outer side flow passage 32 toward the discharge port 30a of the first outer side flow passage 30, and the first gas flow rate is made larger than the second gas flow rate.

Accordingly, in the film forming apparatus 10 of the illustrated example, the residence time of the raw material gas in the mixing portion is controlled, and both an improvement in film forming speed and suppression of aggregation of the active species can be achieved.

Here, as described above, in the atmospheric plasma film formation using the remote diffusion mixing type, normally, the pair of electrodes and the substrate Z are relatively moved and then the film formation is performed.

However, in the present embodiment of the present invention, even in a case where the film formation is performed by relatively moving the pair of electrodes and the substrate Z, it is sufficient that the first gas flow rate and the second gas flow rate are unequal in a state in which the relative movement between the pair of electrodes and the substrate Z is stopped. That is, in the present embodiment of the present invention, the first gas flow rate and the second gas flow rate are measured to determine whether the first gas flow rate and the second gas flow rate are equal or unequal in a state in which the relative movement between the pair of electrodes and the substrate Z is stopped.

Further, the present embodiment of the present invention suitably copes with a case where a relative movement speed between the pair of electrodes and the substrate Z is low. Specifically, in the present embodiment of the present invention, the relative movement speed between the pair of electrodes and the substrate Z is preferably 1.0 m/min or less, and more preferably 0.2 m/min or less.

As described above, the present embodiment of the present invention includes performing the film formation without relatively moving the pair of electrodes and the substrate Z. Therefore, there is no lower limit to the relative movement speed between the pair of electrodes and the substrate Z.

In the present embodiment of the present invention, as long as the first gas flow rate and the second gas flow rate are unequal, a difference between the two flow rates is not limited. In other words, in a case where, in the first gas flow rate and the second gas flow rate, the one with the larger flow rate is defined as a flow rate A and the one with the smaller flow rate is defined as a flow rate B, a flow rate ratio A/B between the flow rate A and the flow rate B is not limited as long as the flow rate ratio exceeds 1.

That is, in the present embodiment of the present invention, an optimum flow rate ratio A/B differs depending on a type of the process gas and the raw material gas, concentration of each gas supplied to each flow passage, a target film forming speed, a shape and configuration of the electrode, power and frequency of an AC voltage applied to the cylindrical electrode 12, or the like.

Therefore, the flow rate ratio A/B of the first gas flow rate and the second gas flow rate may be appropriately set according to the above examples.

The flow rate ratio A/B is preferably 1.0001 to 10000, and more preferably 1.01 to 10.

By setting the flow rate ratio A/B to this range, the residence time of the raw material gas in the mixing portion can be suitably controlled, and the film formation can be performed on a film having higher flatness at a high film forming speed.

In the present embodiment of the present invention, in some cases, the first gas flow rate and the second gas flow rate cannot be measured between the discharge port 30a of the first outer side flow passage 30 and the substrate Z, and between the discharge port 32a of the second outer side flow passage 32 and the substrate Z, depending on a configuration and size of the film forming apparatus, a shape of the electrode, a gap between the electrode and the substrate Z, or the like.

In such a case, the first gas flow rate and the second gas flow rate may be measured at a position where the gas flow rate can be measured on an extension line in a direction in which the discharge port 30a of the first outer side flow passage 30 and the discharge port 32a of the second outer side flow passage 32 are spaced apart from each other.

For example, in a case where the film formation is performed while transporting the substrate Z as described above, the first outer side flow passage 30 (the discharge port 30a) and the second outer side flow passage 32 (the discharge port 32a) are provided with the inner side flow passage (the discharge port 20a) interposed therebetween in the transport direction. Therefore, in a case where the substrate Z is transported from the first outer side flow passage 30 toward the second outer side flow passage 32, the first gas flow rate and the second gas flow rate may be measured at positions where the gas flow rate can be measured an upstream side of the discharge port 30a and a downstream side of the discharge port 32a in the transport direction of the substrate Z.

As described above, in the present embodiment of the present invention, a gas flow rate between the discharge port 30a of the first outer side flow passage 30 and the substrate Z is defined as the first gas flow rate, and a gas flow rate between the discharge port 32a of the second outer side flow passage 32 and the substrate Z is defined as the second gas flow rate, and the first gas flow rate and the second gas flow rate are made unequal.

Therefore, the gas flow direction between the substrate Z and the electrode is substantially a direction from the discharge port 30a toward the discharge port 32a or the opposite direction.

Therefore, in a case where the gas flow rate is measured on the extension line in the direction in which the discharge port 30a and the discharge port 32a are spaced apart from each other, it can be determined whether the first gas flow rate and the second gas flow rate are equal or unequal. Further, the flow rate ratio of the gas flow rate measured on the extension line in the direction in which the discharge port 30a and the discharge port 32a are separated from each other is substantially the same as the flow rate ratio A/B of the first gas flow rate and the second gas flow rate.

For example, in the case of the film forming apparatus 10 of the illustrated example, the gas flow rate may be measured at an end portion of the film forming unit 14 in the lateral direction, which is on the extension line in the direction in which the discharge port 30a and the discharge port 32a are spaced apart from each other.

In the present embodiment of the present invention, the introduction of the raw material gas from both the first outer side flow passage 30 and the second outer side flow passage 32 is not necessarily limited.

That is, the introduction of the raw material gas may be performed on only one of the first outer side flow passage 30 or the second outer side flow passage 32, and for the other, only inert gas that is similar to the plasma generation gas may be introduced, for example. In this case, from the viewpoint of controllability of the gas flow of the raw material gas, it is preferable that the raw material gas is introduced from the outer side flow passage where the introduction amount of gas is large.

However, from the viewpoint that the film forming speed can be increased, it is preferable that the raw material gas is introduced from both the first outer side flow passage 30 and the second outer side flow passage 32.

As described above, in the film forming apparatus 10 of the illustrated example, as a flow rate control unit in the film forming apparatus of the present embodiment of the present invention, the first gas flow rate and the second gas flow rate are made unequal by setting the introduction amount of gas from the first outer side flow passage 30 to the mixing portion to be different from the introduction amount of gas from the second outer side flow passage 32 to the mixing portion.

However, in the present embodiment of the present invention, the method of making the first gas flow rate and the second gas flow rate unequal, that is, the flow rate control unit in the film forming apparatus of the present embodiment of the present invention is not limited to this, and various methods can be used.

As an example, a method of making the first gas flow rate and the second gas flow rate unequal is exemplified by equalizing the introduction amounts of the gas from the first outer side flow passage 30 and the second outer side flow passage 32 and setting the discharge port 30a of the first outer side flow passage 30 and the discharge port 32a of the second outer side flow passage 32 different in area. In the illustrated example, a method of making the first gas flow rate and the second gas flow rate unequal is exemplified by setting the widths of the slits to different widths.

For example, the introduction amounts of the gas are made equal, and the width of the slit of the discharge port 32a is made smaller than that of the discharge port 30a. As a result, the flow velocity of the gas introduced from the discharge port 32a is faster than the flow velocity of the gas introduced from the discharge port 30a. As a result, similar to Fig. 2, a gas flow is formed in the surface direction of the substrate Z from the discharge port 32a of the second outer side flow passage 32 toward the discharge port 30a of the first outer side flow passage 30, and the first gas flow rate can be made larger than the second gas flow rate.

As another method, a method is exemplified in which an air supply unit that supplies gas is provided on an opposite side of the inner side flow passage (the discharge port 20a) of the first outer side flow passage 30 (the discharge port 30a) or the second outer side flow passage 32 (the discharge port 32a), and the first gas flow rate and the second gas flow rate are made unequal by supplying film-like gas (curtain gas) from the air supply unit, for example.

For example, in the film forming unit 14, a gas film forming unit is provided on a side opposite to the inner side flow passage of the second outer side flow passage 32 to supply the curtain gas toward the substrate Z. The flow of the gas from the second outer side flow passage 32 toward the right side is cut off by the curtain gas. As a result, similar to Fig. 2, a gas flow is formed in the surface direction of the substrate Z from the discharge port 32a of the second outer side flow passage 32 toward the discharge port 30a of the first outer side flow passage 30, and the first gas flow rate can be made larger than the second gas flow rate.

As another method, a method is exemplified in which an exhaust unit is provided on an opposite side of the inner side flow passage (the discharge port 20a) of the first outer side flow passage 30 (the discharge port 30a) or the second outer side flow passage 32 (the discharge port 32a), and the first gas flow rate and the second gas flow rate are made unequal by discharging gas from the exhaust unit.

For example, in the film forming unit 14, the exhaust unit is provided on a side opposite to the inner side flow passage of the first outer side flow passage 30, and the gas is exhausted from here. As a result, similar to Fig. 2, a gas flow is formed in the surface direction of the substrate Z from the discharge port 32a of the second outer side flow passage 32 toward the discharge port 30a of the first outer side flow passage 30, and the first gas flow rate can be made larger than the second gas flow rate.

As further another method, a method is exemplified in which the first gas flow rate and the second gas flow rate are made unequal by creating a pressure distribution between the substrate Z and the electrode by setting the shape of a region of the electrode facing the substrate Z different between the first outer side flow passage 30 side and the second outer side flow passage 32 side.

For example, in the film forming unit 14, a distance between the film forming unit 14 on the second outer side flow passage 32 side and the substrate Z is made smaller than a distance between the film forming unit 14 on the first outer side flow passage 30 side and the substrate Z. As a result, the pressure with the substrate Z is higher on the second outer side flow passage 32 side than on the first outer side flow passage 30 side, and similar to Fig. 2, a gas flow is formed in the surface direction of the substrate Z from the discharge port 32a of the second outer side flow passage 32 toward the discharge port 30a of the first outer side flow passage 30, and the first gas flow rate can be made larger than the second gas flow rate.

Note that, in the present embodiment of the present invention, two or more of these methods may be used in combination to make the first gas flow rate and the second gas flow rate unequal.

Further, these methods can also be used in the configurations shown in JP2009-506496A and Fig. 8.

Although the film forming method and the atmospheric plasma film forming apparatus of the embodiment of the present invention have been described in detail above, the embodiment of the present invention is not limited to the above Examples, and various improvements and modifications may be made without departing from the scope of the embodiment of the present invention.

### Examples

Hereinafter, the embodiment of the present invention will be described in more detail with reference to specific Examples of the present invention.

However, the embodiment of the present invention is not limited to the following Examples.

### [Examples]

A DLC film was used for the film formation on the substrate Z using the film forming apparatus 10 shown in Fig. 1.

As the substrate Z, a silicon substrate having a thickness of 0.8 mm was used.

A distance between the lowermost portion of the cylindrical electrode 12 and the lower surface of the film forming unit 14, and the substrate Z was set to 2 mm.

The cylindrical electrode 12 was used in which the surface of a stainless steel cylinder having a diameter of 17 mm and a height of 60 mm was covered with quartz glass having a thickness of 1.5 mm.

The film forming unit 14 was made of stainless steel. The cylindrical-shaped flow passage formation portion 20 was provided at the center of the film forming unit 14 in the lateral direction such that the lower part is open. Further, the plasma generation gas supply passage 24 was formed to communicate with the flow passage formation portion 20.

The cylindrical electrode 12 was inserted into the flow passage formation portion 20 such that the centers of the cylinders coincided with each other. A distance between the cylindrical electrode 12 and the film forming unit 14 (the inner wall surface of the flow passage formation portion 20) was set to 1.5 mm. The inner side flow passage was formed between the cylindrical electrode 12 and the film forming unit 14 as described above.

Further, the film forming unit 14 was formed with the first raw material gas supply passage 26 and the first outer side flow passage 30, and the second raw material gas supply passage 28 and the second outer side flow passage 32. The slit widths of the discharge port 30a of the first outer side flow passage 30 and the discharge port 32a of the second outer side flow passage 32 were set to 0.5 mm. Further, in both outer side flow passages, the regions toward the discharge ports were set to an angle of 18° (162°) with respect to the horizontal direction.

The AC power source 16 having a frequency of 27.12 MHz was connected to the cylindrical electrode 12.

Further, the film forming unit 14 was grounded.

The film formation was performed on the substrate Z using such a film forming apparatus 10.

Mixed gas of 99.1 vol% of argon gas, 0.7 vol% of nitrogen gas, and 0.2 vol% of oxygen gas was supplied to the inner side flow passage. The introduction amount of mixed gas to the mixing portion was set to 2.3 L/min.

On the other hand, mixed gas of 99 vol% of argon gas and 1 vol% of propane gas was supplied to the first outer side flow passage 30 and the second outer side flow passage 32.

The output of the AC power source 16 was set to 600 W.

The film forming atmosphere was set to normal temperature and normal pressure.

The film formation was performed in a state in which the substrate Z was in a stationary state (the substrate transportation speed was 0 mm/sec).

Under the above conditions, the film formation was performed by fixing the introduction amount of the gas from the first outer side flow passage 30 to the mixing portion to 6.7 L/min and changing the introduction amount of the gas from the second outer side flow passage 32 to the mixing portion to 6.7 L/min, 6.8 L/min, 7.3 L/min, 8.0 L/min, 8.8 L/min, and 16.8 L/min. Further, as another example, the film formation was performed by fixing the introduction amount of the gas from the second outer side flow passage 32 to the mixing portion to 6.7 L/min and changing the introduction amount of the gas from the first outer side flow passage 30 to the mixing portion to 0.67 L/min and 0.067 L/min.

Therefore, an introduction amount ratio (an introduction amount ratio of the second outer side flow passage/the first outer side flow passage) of the introduction amount of gas from the first outer side flow passage 30 and the introduction amount of gas from the second outer side flow passage 32 is 1, 1.01, 1.1, 1.2, 1.3, 2.5, 10, and 100.

Further, a gas flow velocity [m/sec] was measured during the film formation, in the lateral direction of the film forming unit 14, that is, in the direction in which the first outer side flow passage 30 and the second outer side flow passage 32 are spaced apart from each other, on an outer side of the first outer side flow passage 30 side and an outer side of the second outer side flow passage 32 side in the lateral direction of the film forming unit 14.

The result is shown in Fig. 5.

Note that, in Fig. 5, the flow velocity is specifically shown only in a case where the introduction amount ratios are 1, 1.1, 1.2, and 1.3 as representative data.

As shown in Fig. 5, in an example in which the introduction amount ratio is other than 1, there is a large difference in flow velocity between the outer side of the first outer side flow passage 30 side and the outer side of the second outer side flow passage 32 side. Therefore, in an example in which the introduction amount ratio is other than 1, the first gas flow rate between the discharge port 30a of the first outer side flow passage 30 and the substrate Z and the second gas flow rate between the discharge port 32a of the second outer side flow passage 32 and the substrate Z are unequal.

Specifically, as described above, in the present example, a distance between the film forming unit 14 and the substrate Z is 2 mm. Further, the length of the film forming unit 14 in a direction orthogonal to the paper surface is 60 mm.

Therefore, the gas flow rates on the first outer side flow passage 30 side and the second outer side flow passage 32 side at the introduction amount ratio of 1.0 are 5.6 L/min.

In the introduction amount ratio of 1.01, the gas flow rate on the first outer side flow passage 30 side is 5.6 L/min, and the gas flow rate on the second outer side flow passage 32 side is 5.5 L/min.

In the introduction amount ratio of 1.1, the gas flow rate on the first outer side flow passage 30 side is 5.8 L/min, and the gas flow rate on the second outer side flow passage 32 side is 3.7 L/min.

In the introduction amount ratio of 1.2, the gas flow rate on the first outer side flow passage 30 side is 6.8 L/min, and the gas flow rate on the second outer side flow passage 32 side is 4.7 L/min.

In the introduction amount ratio of 1.3, the gas flow rate on the first outer side flow passage 30 side is 8.3 L/min, and the gas flow rate on the second outer side flow passage 32 side is 4.7 L/min.

In the introduction amount ratio of 2.5, the gas flow rate on the first outer side flow passage 30 side is 16.2 L/min, and the gas flow rate on the second outer side flow passage 32 side is 4.2 L/min.

In the introduction amount ratio 10, the gas flow rate on the first outer side flow passage 30 side is 4.8 L/min, and the gas flow rate on the second outer side flow passage 32 side is 1.5 L/min. Further, in the introduction amount ratio 100, the gas flow rate on the first outer side flow passage 30 side is 4.0 L/min, and the gas flow rate on the second outer side flow passage 32 side is 1.8 L/min.

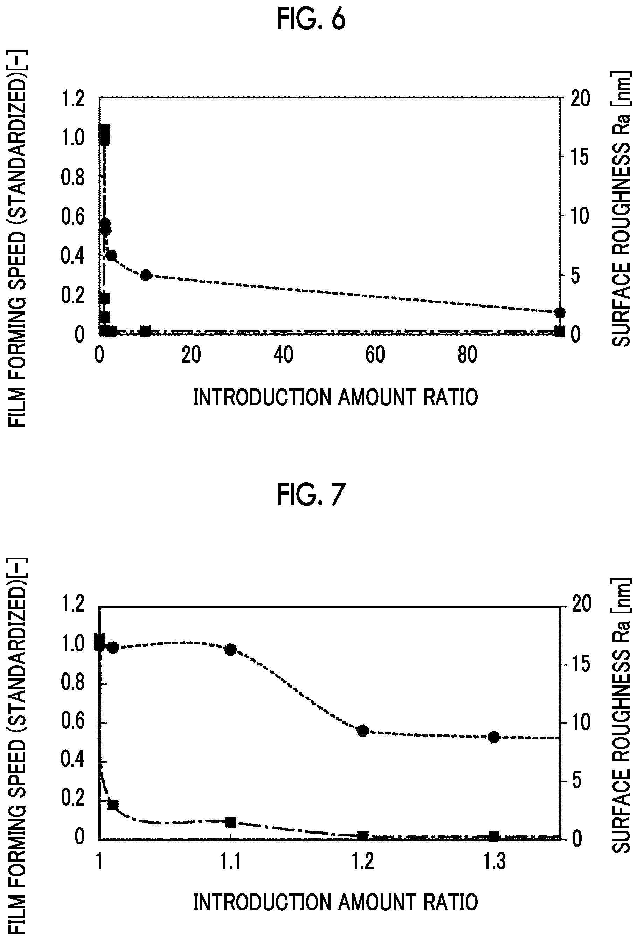

The film forming speed and a surface roughness Ra (an arithmetic average roughness Ra) of the film in which the film formation is performed at each introduction amount ratio were measured. The result is shown in Fig. 6. Further, Fig. 7 shows the results of expanding the region where the introduction amount ratio of the gas is 1 to 1.3.

The film forming speed was standardized based on the example of the flow rate ratio 1.

Further, the surface roughness Ra was measured according to JIS B 0601 2001 by using an atomic force microscope.

In Figs. 6 and 7, the broken line indicates the film forming speed, and the one-point chain line indicates the surface roughness Ra.

As shown in Figs. 6 and 7, the film forming speed and surface roughness Ra of the film, which is used for the film formation, fluctuate by making the introduction amounts of gas to the mixing portion unequal between the first outer side flow passage 30 and the second outer side flow passage 32, that is, by making the first gas flow rate between the discharge port 30a of the first outer side flow passage 30 and the substrate Z and the second gas flow rate between the discharge port 32a of the second outer side flow passage 32 and the substrate Z unequal.

In the present example, by setting the introduction amount ratio of the second outer side flow passage/first outer side flow passage to 1.1, the surface roughness Ra can be made substantially 1.5 nm while maintaining the longest residence time of the raw material gas in the mixing portion and maintaining a film forming speed equivalent to the introduction amount ratio of 1, which is considered to be the highest film forming speed.

From the above results, the effect of Examples of the present embodiment of the present invention is clear.

It can be suitably used for film formation in the manufacture of various products.

### Explanation of References

10: (atmospheric plasma) film forming apparatus
12: cylindrical electrode
14: film forming unit
16: AC power source
20: flow passage formation portion
20a, 30a, 32a: discharge port
24: plasma generation gas supply passage
26: first raw material gas supply passage
28: second raw material gas supply passage
30: first outer side flow passage
32: second outer side flow passage
100: pair of electrodes
102: external electrode
PG: plasma generation gas
MG: raw material gas

## Claims

1. A film forming method comprising:
in a case where, between a pair of electrodes and a substrate, plasma generation gas is introduced from an inner side flow passage that passes between the pair of electrodes and raw material gas is also introduced from at least one of a first outer side flow passage or a second outer side flow passage that are positioned on an outer side between the pair of electrodes, and then a film formation is performed on the substrate by using atmospheric plasma, and
in a case where a gas flow rate between an outlet port of the first outer side flow passage and the substrate is defined as a first gas flow rate, and a gas flow rate between an outlet port of the second outer side flow passage and the substrate is defined as a second gas flow rate,
performing the film formation on the substrate by making the first gas flow rate and the second gas flow rate unequal.

2. The film forming method according to claim 1,
wherein the raw material gas is introduced from at least an outer side flow passage corresponding to a higher flow rate side of the first gas flow rate and the second gas flow rate.

3. The film forming method according to claim 1 or 2,
wherein the raw material gas is introduced from both sides of the first outer side flow passage and the second outer side flow passage.

4. The film forming method according to any one of claims 1 to 3,
wherein the first gas flow rate and the second gas flow rate are made unequal by setting an introduction amount of gas from the first outer side flow passage and an introduction amount of gas from the second outer side flow passage different from each other.

5. The film forming method according to any one of claims 1 to 4,
wherein the first gas flow rate and the second gas flow rate are made unequal by setting the outlet port of the first outer side flow passage and the outlet port of the second outer side flow passage different in area.

6. The film forming method according to any one of claims 1 to 5,
wherein the first gas flow rate and the second gas flow rate are made unequal by providing an air supply unit on one of the first outer side flow passage or the second outer side flow passage on a side opposite to the inner side flow passage and by supplying air from the air supply unit.

7. The film forming method according to any one of claims 1 to 6,
wherein the first gas flow rate and the second gas flow rate are made unequal by providing an exhaust unit on one of the first outer side flow passage or the second outer side flow passage on a side opposite to the inner side flow passage and by discharging gas from the exhaust unit.

8. The film forming method according to any one of claims 1 to 7,
wherein the first gas flow rate and the second gas flow rate are made unequal by setting a shape of a surface, which faces the substrate, of an electrode forming the pair of electrodes different between the first outer side flow passage side and the second outer side flow passage side.

9. An atmospheric plasma film forming apparatus comprising:
a pair of electrodes;
a substrate holding unit that holds a substrate;
an inner side flow passage that passes between the pair of electrodes and that allows gas to be introduced between the pair of electrodes and the substrate holding unit;
a first outer side flow passage and a second outer side flow passage that pass through an outer side between the pair of electrodes and that allow gas to be introduced between the pair of electrodes and the substrate holding unit; and
a flow rate control unit that makes, in a case where a gas flow rate between an outlet port of the first outer side flow passage and the substrate holding unit is defined as a first gas flow rate, and a gas flow rate between an outlet port of the second outer side flow passage and the substrate holding unit is defined as a second gas flow rate, the first gas flow rate and the second gas flow rate unequal.
